**Europäisches Patentamt**

**European Patent Office**

**Office européen des brevets**

(11) Veröffentlichungsnummer: **0 161 516**
**A1**

# (12) EUROPÄISCHE PATENTANMELDUNG

(21) Anmeldenummer: **85104630.0**

(22) Anmeldetag: **17.04.85**

(51) Int. Cl.⁴: **H 03 K 17/18**

(30) Priorität: **30.04.84 DE 3416046**

(43) Veröffentlichungstag der Anmeldung: **21.11.85**
**Patentblatt 85/47**

(84) Benannte Vertragsstaaten: **AT CH DE FR GB IT LI SE**

(71) Anmelder: **Siemens Aktiengesellschaft, Berlin und München Wittelsbacherplatz 2, D-8000 München 2 (DE)**

(72) Erfinder: **Vettari, Giancarlo, Don-Bosco-Strasse 7, D-8450 Amberg (DE)**

(54) **Elektronischer Schalter.**

(57) Die Erfindung betrifft einen elektronischen Schalter (1), mit TSE-Beschaltung (5, 6) und einer in Reihe an ein Wechselspannungsnetz geschalteten Last (2). Im Ansteuerkreis des Triac (1) liegt eine Gleichrichterbrückenschaltung (9) mit den Wechselstromanschlüssen (11), an deren Gleichstromanschlüssen eine in Durchlaßrichtung geschaltete Leuchtdiode (13) angeschlossen ist. Da sich der Zündstrom für den Triac (1) periodisch wiederholt, zeigt die Leuchtdiode (13) den Schaltzustand des Triacs (1) an; denn die kurzen stromlosen Pausen für die LED werden infolge der Trägheit des menschlichen Auges nicht wahrgenommen.

Siemens Aktiengesellschaft  
Berlin und München

Unser Zeichen  
VPA **84 P 3 1 5 0 E**

## Elektronischer Schalter

Die Erfindung bezieht sich auf einen elektronischen Schalter, insbesondere Triac mit TSE (Träger-Speicher-Effekt) Beschaltung und einer in Reihe an ein Wechselspannungsnetz geschalteten Last und einer Schaltzustandsanzeige sowie einer Ansteuerschaltung für den elektrischen Schalter.

Beim bekannten Schalter der o.g. Art ist zur Schaltzustandsanzeige eine Glimmlampe parallel zur Last geschaltet, die den Einschaltzustand des Schalters signalisieren soll. Unter ungünstigen Bedingungen jedoch, beispielsweise bei nicht angeschlossener Last leuchtet die Glimmlampe in Folge der TSE-Beschaltung auch auf, wenn der elektronische Schalter nicht leitend ist.

Der Erfindung liegt die Aufgabe zugrunde, für einen elektronischen Schalter der o.g. Art eine Schaltzustandsanzeige zu schaffen, die einfach aufgebaut eine sichere Anzeige bietet.

Dies wird auf einfache Weise dadurch erreicht, daß im Ansteuerkreis eine Gleichrichterbrückenschaltung mit ihren Wechselstromanschlüssen liegt, an deren Gleichstromanschlüssen in Durchlaßrichtung eine Leuchtdiode (LED) angeschlossen ist. Als Vorteil hat sich hier erwiesen, wenn im Ansteuerkreis ein Optotriac mit in Reihe geschalteten Schutzwiderstand liegt.

La 2 Ts / 19.04.1984

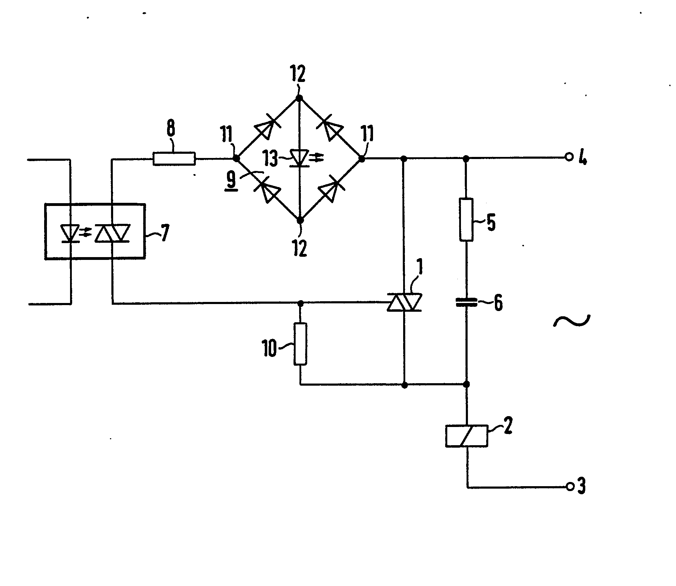

Anhand der Zeichnung wird ein Ausführungsbeispiel der Erfindung beschrieben.

Der elektronische Schalter besteht aus einem Triac 1, der mit der Last 2, beispielsweise eine Schützspule, in Reihe an den Netzklemmen 3, 4 des Wechselstromnetzes liegt. Dem Triac parallelgeschaltet ist die sogenannte TSE-Beschaltung (Träger-Speicher-Effekt), die aus der Reihenschaltung des Widerstandes 5 und des Kondensators 6 besteht. Zur Ansteuerung des Triacs 1 dient ein Optotriac 7, der mit der einen Seite am Gerät des Triacs und mit der anderen Seite über einen Schutzwiderstand 8 und eine Gleichrichterbrückenschaltung 9 an der einen Anode des Triacs 1 liegt. Ein Widerstand 10 liegt mit dem einen Ende am Gerät und mit dem anderen Ende an der anderen Anode des Triacs 1. Die Gleichrichterbrückenschaltung 9 liegt mit den Wechselstromanschlüssen 11 im Ansteuerkreis des Triacs. An den Gleichstromanschlüssen 12 der Gleichrichterbrückenschaltung 9 liegt in Durchlaßrichtung eine Leuchtdiode 13.

Wird der Optotriac angesteuert, so fließt von der Netzklemme 4 über die Gleichrichterbrückenschaltung 9, den Schutzwiderstand 8, den Optotriac 7, über Gate-Kathode des Triacs und die Last 2 der Zündstrom für den Triac. Der vor dem Durchsteuern des Triacs im Ansteuerkreis fließende Strom reicht aus, um die Leuchtdiode 13 zum Leuchten zu bringen. Da der Zündvorgang bei Wechselspannung periodisch wiederholt wird, kann die Leuchtdiode 13 den Schaltzustand des Triacs anzeigen; denn das Auge des Beobachters nimmt das kurzzeitige Erlöschen der Leuchtdiode nicht wahr.

2 Patentansprüche
1 Figur

Patentansprüche

1. Elektronischer Schalter, insbesondere Triac mit TSE (Träger-Speicher-Effekt) Beschaltung und einer in Reihe an ein Wechselspannungsnetz geschalteten Last und einer Schaltzustandsanzeige sowie einer Ansteuerschaltung für den elektrischen Schalter, d a d u r c h   g e k e n n - z e i c h n e t , daß im Ansteuerkreis eine Gleich- richterbrückenschaltung (9) mit ihren Wechselstroman- schlüssen (11) liegt, an deren Gleichstromanschlüssen (12) in Durchlaßrichtung eine Leuchtdiode (LED) (13) angeschlossen ist.

2. Schalter nach Anspruch 1, d a d u r c h   g e - k e n n z e i c h n e t , daß im Ansteuerkreis ein Optotriac (7) mit in Reihe geschalteten Schutzwider- stand (8) liegt.

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | US-A-4 065 683 (CLARKE) <br> * Spalte 3, Zeile 57 - Spalte 4, Zeile 35; Figur 3 * <br><br> --- | 1 | H 03 K 17/18 |
| A | EDN MAGAZINE, Nr. 13, Juni 1981, Seiten 192,196, Boston, Massachusetts, US; J.R. BRYTTAN: "Three ICs control triacs digitally" <br> * Seite 192; Figur * <br><br> ----- | 2 | |
| | | | **RECHERCHIERTE SACHGEBIETE (Int. Cl.4)** <br><br> H 03 K <br> H 02 M |

Der vorliegende Recherchenbericht wurde für alle Patentansprüche erstellt.

| Recherchenort <br> DEN HAAG | Abschlußdatum der Recherche <br> 01-08-1985 | Prüfer <br> CANTARELLI R.J.H. |
|---|---|---|